# EUROPÄISCHE PATENTSCHRIFT

(11) **EP 1 341 720 B1**
(45) Veröffentlichungstag und Bekanntmachung des Hinweises auf die Patenterteilung: **26.01.2005**
(21) Anmeldenummer: 01983594.1
(22) Anmeldetag: 21.11.2001
(51) Int. Cl.: C01B 33/029, C01B 33/039, H01L 31/18

(54) **VERFAHREN ZUR HERSTELLUNG VON REINSTSILICIUM**
METHOD FOR THE PRODUCTION OF HIGH PURITY SILICON
PROCEDE DE PRODUCTION DE SILICIUM EXTRAPUR

(30) Priorität: 11.12.2000 DE 10061682
(43) Veröffentlichungstag der Anmeldung: 10.09.2003
(73) Patentinhaber: SOLARWORLD AKTIENGESELLSCHAFT, 53113 Bonn (DE)
(72) Erfinder: BLOCK, Hans-Dieter, Dr., 51381 Leverkusen (DE); MLECZKO, Leslaw, Dr., 44801 Bochum (DE); LEIMKÜHLER, Hans-Joachim, Dr., 51375 Leverkusen (DE); WEBER, Rainer, Dr., 51519 Odenthal (DE); WERNER, Knud, Dr., 47800 Krefeld (DE); SCHWANKE, Dietmar, 40789 Monheim (DE); SCHÄFER, Johannes-Peter, 51515 Kürten (DE); WAGNER, Gebhard, Dr., 51519 Odenthal (DE)
(74) Vertreter: Rau, Albrecht
(86) Internationale Anmeldenummer: PCT/EP2001/013507
(87) Internationale Veröffentlichungsnummer: WO 2002/048034

(56) Entgegenhaltungen:
- DD-A- 158 322
- US-A- 4 340 574
- US-A- 4 676 967
- PATENT ABSTRACTS OF JAPAN vol. 005, no. 140 (C-070), 4. September 1981 (1981-09-04) & JP 56 073617 A (OSAKA TITANIUM SEIZO KK), 18. Juni 1981 (1981-06-18)

## Beschreibung

Die vorliegende Erfindung betrifft ein Verfahren zur Herstellung von Reinstsilicium durch Umsetzung von metallurgischem Silicium mit Siliciumtetrachlorid (SiCl₄), Wasserstoff (H₂) und Chlorwasserstoff (HCl), Entfernung von Verunreinigungen aus dem entstehenden trichlorsilanhaltigen (SiHCl₃) Rohgasstrom, Disproportionierung des SiHCl₃ zu SiCl₄ und Silan (SiH₄) und thermische Zersetzung des SiH₄ zu hochreinem Silicium.

Reinstsilicium wird bei der Herstellung von Halbleitern und Solarzellen benötigt. Dabei werden sehr hohe Anforderungen an die Reinheit des Siliciums gestellt. Die Herstellung von Reinstsilicium, das diese Anforderungen erfüllt, erfolgt gemäß "Silicon for the Chemical Industry IV, Geiranger, Norway, June 3-5, 1998, Ed.: H.A. ⌀ye, H.M. Rong, L. Nygaard, G.Schüssler, J.Kr.Tuset, S. 93 - 112" nach drei unterschiedlichen Verfahren:
- Umsetzung von metallurgischem Silicium mit Chlorwasserstoff (HCl) im Wirbelbett zu SiHCl₃, Reinigung des SiHCl₃, thermische Zersetzung des gereinigten SiHCl₃ in Gegenwart von H₂ an Siliciumstäben zu Reinstsilicium. Das bei der thermischen Zersetzung von SiHCl₃ anfallende SiCl₄-haltige Reaktionsgas wird kondensiert und gereinigt. Nachteilig ist dabei, dass als Nebenprodukt SiCl₄ in großer Menge anfällt das in einem separaten technisch und energetisch sehr aufwendigen Verfahrensschritt zu SiHCl₃ umgesetzt wird oder verwertet werden muss, beispielsweise bei der Herstellung von pyrogener Kieselsäure.
- Umsetzung von Siliciumtetrafluorid (SiF₄) mit Natriumaluminiumhydrid (NaAlH₄) zu SiH₄ und Natriumaluminiumfluorid (NaAlF₄), Reinigung des gebildeten SiH₄, Abscheidung von Reinstsilicium an Siliciumsaatpartikeln in einem Wirbelbett und Entfernung von H₂ aus den gebildeten Reinstsilicium-Granalien. Es fallen große Menge an NaAlF₄ an, die verwertet bzw. vermarktet werden müssen. Ein weiterer Nachteil dieses Verfahrensweges besteht darin, dass bei der Abscheidung von Reinstsilicium im Wirbelbett eine größere Menge an Reinstsiliciumstaub entsteht, der aufgrund fehlender wirtschaftlicher Verwertungswege entsorgt werden muss.
- Umsetzung von metallurgischem Silicium mit SiCl₄ und H₂ in einem Wirbelbett zu SiHCl₃, katalysierte zweistufige Disproportionierung des SiHCl₃ in SiCl₄ und SiH₄, Rückführung des gebildeten SiCl₄ in die Umsetzung von metallurgischem Silicium mit SiCl₄ und H₂, thermische Zersetzung des gebildeten SiH₄ an Siliciumstäben zu Reinstsilicium und Rückführung des dabei gebildeten H₂ in die Umsetzung von metallurgischem Silicium mit SiCl₄ und H₂.

Das letztgenannte Verfahren zeichnet sich dadurch aus, dass ein Zwangsanfall von großen Mengen an Nebenprodukten durch Nutzung des anfallenden SiCl₄ bei der Herstellung von SiHCl₃ durch Umsetzung mit metallurgischem Silicium und Wasserstoff vermieden wird.

Ausführungsformen dieses Verfahrens sind in "Studies in Organic Chemistry 49, Catalyzed Direct Reaktions of Silicon, Elsevier, 1993, S.450 bis 457" und DE 3 311 650 C2 und CA-A-1 162 028 dargelegt. Gemäß diesen Schriften erfolgt die Herstellung von Reinstsilicium nach diesem Verfahren in folgenden Schritten:
1. Umsetzung von metallurgischem Silicium mit SiCl₄ und H₂ bei 400 bis 600°C und einem Druck von 20,7 bis 41,4 bar in einem Wirbelbettreaktor.
2. Entfernung von Verunreinigungen, wie nicht umgesetztes feinteiliges Silicium, Metallchloride und ggf. Katalysator, aus dem entstandenen chlorsilanhaltigen und wasserstoffhaltigen Reaktionsgemisch durch Wäsche des heißen Gasstroms mit kondensierten Chlorsilanen.
3. Entsorgung der dabei anfallenden, feststofthaltigen Chlorsilane-Suspension.
4. Kondensation des gereinigten Reaktionsgemisches.
5. Rückführung des in Schritt 4 anfallenden Wasserstoffs in Schritt 1.
6. Destillative Auftrennung des gereinigten Reaktionsgemisches in SiCl₄ und SiHCl₃.
7. Rückführung von SiCl₄ in Schritt 1.
8. 2-stufige katalysierte Disproportionierung von in Schritt 6 erhaltenem SiHCl₃ zu SiH₄ und SiCl₄.
9. Rückführung von SiCl₄ in Schritt 1.
10. Destillative Reinigung des in Schritt 8 erhaltenen SiH₄.
11. Thermische Zersetzung des gereinigten SiH₄ unter Bildung von Reinstsilicium und von Wasserstoff.
12. Nutzung des gebildeten Wasserstoffs als Verdünnungsgas in Schritt 11 bzw. Rückführung in Schritt 1.

Bei Durchführung von Schritt 1 werden aufgrund langsamer Reaktionsgeschwindigkeiten Ausbeuten erzielt, die deutlich unterhalb der gemäß dem thermodynamischen Gleichgewicht zu erwartenden Ausbeuten liegen. Zur Beschleunigung der Reaktion können gemäß DE 3 311 650 C2 und DE 4 104 422 A1 Kupferkatalysatoren eingesetzt werden. Überlicherweise werden die Kupferkatalysatoren gemeinsam mit dem gemahlenen Silicium oder separat in das Wirbelbett eingetragen. Dies hat den Nachteil, dass im Wirbelbett ein Teil des Katalysators wegen unzureichender Haftung an den Siliciumpartikeln mit den gasförmigen Reaktanden bzw. den Reaktionsprodukten direkt aus dem Wirbelbett ausgetragen wird und somit nicht mehr für die Reaktion zur Verfügung steht. Dieses führt zu einem hohen Bedarf an Kupferkatalysator, was die Wirtschaftlichkeit des Verfahrens aufgrund des in der Regel hohen Preises der Kupferkatalysatoren beeinträchtigt.

Bei der Umsetzung von metallurgischem Silicum mit SiCl₄ und Wasserstoff werden neben den gewünschten Chlorsilanen auch Chloride, wie Aluminiumchlorid (AlCl₃), Eisenchlorid (FeCl₂) und Calciumdichlorid (CaCl₂) gebildet. Diese Metallchloride werden bei der im 2. Schritt durchgeführten Wäsche des heißen Gasstroms mit kondensierten Chlorsilanen zum großen Teil als kristallisierte Feststoffe entfernt. Aufgrund des hohen Sublimationsdrucks kann kristallisiertes AlCl₃ jedoch über den Gasraum in dem gesamten Wäscher verteilt werden. Dies führt zu einer Belegung des Wäschers und seiner Einbauten mit AlCl₃, was regelmäßige Betriebsunterbrechungen und Reinigung des Wäschers erforderlich macht.

Die Entfernung von AlCl₃ durch Destillation der Chlorsilane kann bei herabgesetzten Temperaturen im Vakuum vorgenommen werden. Unter diesen Bedingungen ist der Dampfdruck des festen Aluminiumchlorids so gering, dass sein Anteil in der Gasphase bis unter die Löslichkeitsgrenze sinken kann, so dass das Problem der Abscheidung von festem Aluminiumchlorid in der Apparatur vermieden wird. Allerdings ist es nicht möglich, dadurch den AlCl₃-Anteil unter den Anteil seines Dampfdrucks am gesamten Dampfdruck zu senken, so dass einerseits die Abtrennung von AlCl₃ nur in begrenztem Umfang möglich ist, andererseits das Problem der Aluminiumchlorid-Ausfällung bei erneuter Destillation dadurch erneut auftritt, wenn auch in mengenmäßig reduzierter Form. Eine Teillösung des Problems ist durch die Vorgehensweise der DE 2 161 641 A1 erreicht worden, wobei der den Synthesereaktor verlassende Gasstrom in zwei Stufen durch Zuspeisung von SiCl₄ zunächst auf 250 bis 300°C und danach in einem Venturiwäscher mit weiterem SiCl₄ auf ca. 53°C abgekühlt wird, wobei von den Chlorsilanen mitgeführtes Eisenchlorid und Aluminiumchlorid ausgefällt werden und im Kondensat verbleiben und der den wesentlichen Teil der Chlorsilane enthaltende Gasstrom nochmals mit kondensierten Chlorsilanen gewaschen wird und danach kondensiert werden kann. Der restliche Gehalt an AlCl₃ ist dann gegeben durch den Dampfdruck von AlCl₃ bei ca. 53°C. Bei der weiteren Reinigung der Chlorsilane tritt dann wieder das oben beschriebene Problem der Anreicherung des AlCl₃ im Sumpf auf, mit der Folge der Bildung einer festen Phase von AlCl₃ und dessen unerwünschter Sublimation. In ganz ähnlicher Weise wird nur eine Teillösung erreicht durch das Verfahren der DE 2 623 290 A1, wobei der Gasstrom, enthaltend die Chlorsilane und das AlCl₃, auf 60 bis 80°C abgekühlt wird zum Zweck der Ausfällung des festen AlCl₃ und dessen Abtrennung.

Die Entsorgung der in Schritt 2 anfallenden silicummetall- und metallchloridhaltigen Chlorsilane-Suspension erfolgt gemäß DE 3 709 577 A1 durch eine spezielle destillative Auftrennung der Chlorsilane und der Festoffe, wobei ein großer Teil der Chlorsilane wiedergewonnen werden kann. Der verbleibende feststoff- und chlorsilanehaltige Destillaüonssumpf kann nicht verwertet werden und muss deshalb einer Abfallentsorgung zugeführt werden, wie sie beispielsweise in US-A-4 690 810 beschrieben ist. Diese Vorgehensweise beeinträchtigt die Wirtschaftlichkeit des Verfahrens. Ein weiterer Nachteil besteht darin, dass mit den zurückgewonnen Chlorsilanen störende Verunreinigungen in den Prozess zur Herstellung von Reinstsilicium zurückgeführt werden, was zu einer unerwünschten Anreicherung dieser Verunreinigungen und damit zu einer Prozessbeeinträchtigung führen kann.

Bei den Schritten 4, 6, 8 und 10 fallen silan- und chlorsilanhaltige Abfallströme an, die in der Regel durch Wäsche mit Lösungen von Alkaliverbindungen oder beispielsweise durch Verbrennung entsorgt werden. Verfahrenvarianten zur Entsorgung der Abfallströme sind beispielsweise in US-A-4 519 999 beschrieben. Bei diesen Verfahren werden die reaktiven Siliciumverbindungen durch Überführung in Silikate oder Kieselsäuren unschädlich gemacht. Dieses Vorgehen hat aber den Nachteil, dass die an sich wertvollen Abfallstrombestandteile wie SiH₄, SiH₂Cl₂, SiHCl₃ und SiCl₄ in minderwertige Produkte umgewandelt werden.

Die im 8. Schritt durchgeführte 2-stufige katalysierte Disproportionierung von SiHCl₃ zu SiH₄ und SiCl₄ ist apparativ und energetisch sehr aufwendig. Ein verbesserte Verfahrensvariante besteht gemäß DE 2 507 864 A1 darin, die Disproportionierung von SiHCl₃ in einem Schritt nach dem Prinzip der Reaktivdestillation ablaufen zu lassen. Allerdings besteht ein schwerwiegender Nachteil dieses in der DE 2 507 864 A1 beschriebenen Verfahrens darin, dass der für die Trennung der Silane oder Chlorsilane aufgewendete Energiebetrag vollständig auf einem den Kondensationstemperaturen entsprechenden sehr niedrigen Temperaturniveau von unterhalb - 50°C bis -120°C abgeführt werden muss. Eine Wärmeabfuhr auf niedrigem Temperaturniveau ist bekanntermaßen aufwendig und mit hohem Energieverbrauch verbunden.

Die in Schritt 11 durchgeführte thermische Zersetzung von gereinigtem SiH₄ kann gemäß DE 3 311 650 C2 nach drei unterschiedlichen Verfahren erfolgen:
A. Halbkontinuierliche Abscheidung von Reinstsilicium an Siliciumstäben, bekannt als Siemens-Verfahren.
B. Kontinuierliche Zersetzung von SiH₄ in einem Gasphasenreaktor unter Bildung von staubförmigem Reinstsilicium.
C. Kontinuierliche Zersetzung von SiH₄ an Siliciumkeimpartikeln in einem Wirbelbett unter Bildung von Reinstsilicium-Granalien.

Verfahrensvariante A ist apparativ sehr aufwendig und erfordert aufgrund der zwangsläufig gegebenen halbkontinuierlichen Fahrweise regelmäßige Anlagenstillstände verbunden mit aufwendigen Reinigungsarbeiten. Bei Verfahrensvariante B fällt Reinstsilicium in Form eines nicht direkt einsetzbaren feinteiligen Staubes an, der in aufwendigen Folgeschritten verdichtet und aufgeschmolzen werden muss. Dabei wird dieser Reinstsilicium-Staub aufgrund seiner sehr großen spezifischen Oberfläche leicht kontaminiert und kann deshalb in der Regel nicht auf dem Gebiet der Photovoltaik oder der Halbleitertechnologie eingesetzt werden.

In Verfahrensvariante C werden hingegen im kontinuierlichen Betrieb Reinstsilicium-Granalien gebildet, die problemlos weiterverarbeitet werden können. Varianten dieses Verfahrens sind beispielsweise in US-A-3 012 861 und US-A-5 798 137 beschrieben. Nachteile der Verfahrensvariante C liegen gemäß dieser Schriften darin, dass ein erheblicher Teil des eingesetzten SiH₄ zu staubförmigem Reinstsilicium zersetzt wird. Um die Staubbildung zu vermindern, kann die SiH₄-Zersetzung durch Zusatz von Wasserstoffbei nahezu Atmosphärendruck durchgeführt werden.

Der Reinstsilicium-Staub wird bei einer Verarbeitung in Folgeschritten wie oben geschildert aufgrund seiner sehr großen spezifischen Oberfläche leicht kontaminiert und kann deshalb ebenfalls nicht auf dem Gebiet der Photovoltaik oder der Halbleitertechnologie eingesetzt werden.

Die genannten Nachteile führen dazu, dass die Herstellung von Reinstsilicium immer noch mit sehr hohen Kosten verbunden ist, was insbesondere die Wirtschaftlichkeit und damit verbunden das Wachtums von Photovoltaikanwendungen, bei denen Reinstsilicium eingesetzt wird, erheblich beeinträchtigen.

Die Aufgabe der vorliegenden Erfindung bestand nun darin, ein Verfahren zur Herstellung von Reinstsilicium bereitzustellen, welches die genannten Nachteile nicht aufweist und eine kostengünstige Produktion gestattet.

Die vorliegende Erfindung betrifft ein Verfahren zur Herstellung von Reinstsilicium gekennzeichnet durch die Schritte:
a) Umsetzung von metallurgischem Silicium mit Siliciumtetrachlorid (SiCl₄), Wasserstoff (H₂) und Chlorwasserstoff (HCl) bei einer Temperatur von 500 bis 800°C und einem Druck von 25 bis 40 bar zu einem trichlorsilanhaltigen (SiHCl₃) Rohgasstrom,
b) Entfernung von Verunreinigungen aus dem entstehenden trichlorsilanhaltigen Rohgasstrom durch Wäsche mit kondensierten Chlorsilanen bei einem Druck von 25 bis 40 bar und einer Temperatur von 160 bis 220°C in einer mehrstufigen Destillationskolonne, wobei ein gereinigter trichlorsilanhaltiger Rohgasstrom und eine feststoffhaltige Chlorsilane-Suspension entstehen und destillative Auftrennung des gereinigten Rohgasstroms in einen im wesentlichen aus SiCl₄ und einen im wesentlichen aus SiHCl₃ bestehenden Teilstrom,
c) Disproportionierung des SiHCl₃-haltigen Teilstroms zu SiCl₄ und SiH₄, wobei die Disproportionierung in mehreren reaktiv/destillativen Reaktionsbereichen, die im Gegenstrom von Dampf und Flüssigkeit durchströmt werden, an katalytisch wirkenden Feststoffen unter einem Druck von 500 mbar bis 50 bar durchgeführt wird und wobei einem ersten Reaktionsbereich SiHCl₃ zugeführt wird, das dort erzeugte leichter siedende SiH₄-haltige Disproportionierungs-Produkt im Temperaturbereich von -25°C bis 50°C zwischenkondensiert wird, das dabei nicht kondensierte SiH₄-haltige Produktgemisch in einem oder mehreren weiteren reaktiv/destillativen Reaktionsbereichen geführt wird, und das erzeugte leichter siedende, hohe Anteile an SiH₄ enthaltende Produkt im Kopfkondensator teilweise oder vollständig kondensiert wird, und
d) thermische Zersetzung des SiH₄ zu Reinstsilicium.

Unter Reinstsilicium wird dabei Silicium verstanden, das eine ausreichende Reinheit aufweiset, um für die Verwendung im Bereich der Photovoltaik geeignet zu sein. Dazu ist es erforderlich, dass alle Metallkonzentrationen unterhalb 0,1 ppm liegen, und der Gehalt an Kohlenstoff unter 1 ppm, an Sauerstoff unter 5 ppm, an Phosphor unter 0,1 ppm und and Bor unter 0,05 ppm bleibt.

Unter metallurgischem Silicium wird Silicium verstanden, das bis etwa 3 Gew.-% Eisen, 0,75 Gew.-% Aluminium, 0,5 Gew.-% Calcium und weitere Verunreinigungen enthalten kann, wie sie üblicherweise in Silicium zu finden sind und das vorzugsweise durch carbothermische Reduktion von Siliciumdioxid gewonnen wurde.

Es wurde gefunden, dass bei Durchführung des erfindungsgemäßen Verfahrens eine Reihe von Vorteilen erhalten werden, die eine wesentlich konstengünstigere Herstellung von Reinstsilicium ermöglichen.

Bei Durchführung der Umsetzung von metallurgischem Silicium mit SiCl₄, H₂ und HCl bei einer Temperatur von 500 bis 800°C, vorzugsweise 550 bis 650°C und einem Druck von 25 bis 40 bar, vorzugsweise 30 bis 38 bar werden hohe Raum/Zeit-Ausbeuten an SiHCl₃ erzielt.

Die Zugabe von Chlorwasserstoff, vorzugsweise in einer Menge von 0,05 bis 10 Gew.-%, besonders bevorzugt 1 bis 3 Gew.-%, jeweils bezogen auf die Masse am zugeführen SiCl₄ als zusätzlicher Reaktand bewirkt eine unerwartete Beschleunigung der Umsetzung, die letzlich dazu führt, dass sehr hohe SiHCl₃-Ausbeuten, das heißt hohe Umsetzungsgrade des eingesetzten SiCl₄ in der Nähe des thermodynamischen Gleichgewichts, und gleichzeitig hohe Gesamtausbeuten, d.h. eine weitgehende Verwertung des eingesetzten metallurgischen Siliciums, erreicht werden.

Chlorwasserstoff wird vorzugsweise in wasserfreier Form als Chlorwasserstoffgas eingesetzt.

Chlorwasserstoff kann beispielsweise separat in den Reaktor eingespeist werden, in dem die Umsetzung zu Trichlorsilan durchgeführt werden soll. Es ist jedoch auch möglich, Chlorwasserstoff gemeinsam mit den in den Reaktor einzuführenden, gasförmigen bzw. verdampfbaren Ausgangsstoffen Wasserstoff und/oder Siliciumtetrachlorid zuzuführen.

Die Wahl des Reaktors, in dem die erfindungsgemäße Umsetzung erfolgen soll, ist nicht kritisch, solange der Reaktor unter den Reaktionsbedingungen hinreichende Stabilität aufweist und den Kontakt der Ausgangsstoffe erlaubt. Beispielsweise kann in einem Festbettreaktor, einem Drehrohrofen oder einem Wirbelbettreaktor gearbeitet werden. Die Reaktionsführung in einem Wirbelbettreaktor ist bevorzugt.

Der Werkstoff des Reaktors muss den genannten Reaktionsbedingungen der SiHCl₃-Synthese standhalten. Die Anforderungen an die Beständigkeit der Konstruktionswerkstoffe für den Reaktor gelten ebenso für gegebenenfalls vor- und nachgeschaltete Anlagenteile, wie Zyklone oder Wärmetauscher. Diese Anforderungen werden beispielsweise von Nickelbasislegierungen erfüllt.

Durch den Einsatz von Katalysatoren ist eine weitere Beschleunigung der Reaktion von metallurgischem Silicium mit SiCl₄, H₂ und HCl erreichbar. Besonders geeignete Katalysatoren sind Kupfer, Eisen, Kupfer- oder Eisenverbindungen oder deren Mischungen.

Es hat sich überraschend gezeigt, dass die Katalysatoren dann eine besonders hohe Wirksamkeit entfalten, wenn das metallurgische Silicium in gemahlener Form vorliegt und vor der Reaktion mit den Katalysatoren intensiv vermischt wird.

Vorzugsweise wird daher im erfindungsgemäßen Verfahren die Umsetzung zu Trichlorsilan (Schritt a)) in Gegenwart eines Katalysators durchgeführt, wobei das metallurgische Silicium vor der Reaktion mit dem Katalysator intensiv gemischt wird.

Vorzugsweise wird dabei Silicium mit einem mittleren Korndurchmesser von 10 bis 1000 µm, insbesondere bevorzugt von 100 bis 600 µm, eingesetzt. Der mittlere Korndurchmesser wird dabei als Zahlenmittel der Werte bestimmt, die sich bei einer Siebanalyse des Siliciums ergeben.

Zum Mischen von Katalysator und Silicium werden vorzugsweise Apparate eingesetzt, die eine sehr intensive Vermischung gewährleisten. Hierfür eignen sich besonders Mischer mit rotierenden Mischwerkzeugen. Solche Mischer sind beispielsweise in "Ullmannn's Encyclopedia of Industrial Chemistry, Volume B2, Unit Operations I, S.27-1 bis 27-16, VCH Verlagsgesellschaft, Weinheim" beschrieben. Besonders bevorzugt werden Pflugscharmischer eingesetzt.

Bei dem intensiven Mischen kann der Katalysator weiter zerkleinert werden, was beim Mischvorgang zu einer sehr guten Verteilung und einer sehr guten Anhaftung des Katalysators auf der Siliciumoberfläche führt. Somit können auch Katalysatoren eingesetzt werden, die nicht feinteilig verfügbar sind bzw. nicht auf die erforderliche Feinheit zerkleinerbar sind.

Bei unzureichender Vermischung wird ein großer Teil des Katalysators wegen schlechter Haftung an den Siliciumpartikeln mit den gasförmigen Reaktanden bzw. Produkten direkt aus dem Wirbelbett ausgetragen und steht somit nicht mehr für die Reaktion zur Verfugung. Dies führt zu einem erhöhten Bedarf an Katalysator, was die Wirtschaftlichkeit des Verfahrens beeinträchtigt. Durch die intensive Vermischung von Silicium und Katalysator wird dies verhindert.

Die Zeit für die Vermischung von Silcium und Katalysator beträgt vorzugsweise 1 bis 60 Minuten. Längere Mischzeiten sind in der Regel nicht erforderlich. Besonders bevorzugt sind Mischzeiten von 5 bis 20 Minuten.

Die intensive Vermischung von Katalysator und Silicium kann beispielsweise in inerter Atmosphäre oder in Gegenwart von Wasserstoff oder anderen reduzierend wirkenden Gasen, beispielsweise Kohlenmonoxid erfolgen. Dies verhindert unter anderem die Bildung einer oxidischen Schicht auf den einzelnen Siliciumpartikeln. Eine solche Schicht verhindert den direkten Kontakt zwischen Katalysator und Silicium, wodurch die Umsetzung mit Siliciumtetrachlorid, Wasserstoff und gegebenenfalls Chlorwasserstoff zu Trichlorsilan entsprechend schlechter katalysiert würde.

Eine inerte Atmosphäre kann beispielsweise durch den Zusatz eines inerten Gases während des Vermischungsvorgangs erzeugt werden. Geeignete inerte Gase sind beispielsweise Stickstoff und/oder Argon.

Bevorzugt erfolgt die Vermischung von Silicium und Katalysator in Gegenwart von Wasserstoff.

Als Katalysator können prinzipiell alle für die Umsetzung von Silicium mit Siliciumtetrachlorid, Wasserstoff und gegebenenfalls Chlorwasserstoff bekannten Katalysatoren eingesetzt werden.

Besonders geeignete Katalysatoren sind Kupferkatalysatoren und Eisenkatalysatoren. Beispiele hierfür sind Kupferoxidkatalysatoren (z.B. Cuprokat® , Hersteller Norddeutsche Affinerie), Kupferchlorid (CuCl, CuCl₂), Kupfermetall, Eisenoxide (z.B. Fe₂O₃, Fe₃O₄), Eisenchloride (FeCl₂, FeCl₃) und deren Mischungen.

Bevorzugte Katalysatoren sind Kupferoxidkatalysatoren und Eisenoxidkatalysatoren.

Es hat sich insbesondere beim Einsatz von Kupferoxidkatalysatoren und Eisenoxidkatalysatoren als vorteilhaft erwiesen, die Vermischung mit Silcium bei einer Temperatur von 100 bis 400°C, vorzugsweise bei 130 bis 350°C durchzuführen. Bei dieser Vorgehensweise werden an den Katalysatoren anhaftende Reste von Feuchtigkeit entfernt, die die Reaktion von Silicium mit SiCl₄, H₂ und gegebenenfalls HCl negativ beeinflussen. Darüberhinaus wird durch diese Vorgehensweise eine verbesserte Anhaftung von Katalysator an die Siliciumoberfläche erreicht, wodurch Verluste an Katalysator im Wirbelbett weitgehend vermieden werden.

Es ist auch möglich, Mischungen aus Kupfer- und/oder Eisenkatalysatoren mit weiteren katalytisch aktiven Bestandteilen einzusetzen. Solche katalytisch aktiven Bestandteilen sind beispielsweise Metallhalogenide, wie z.B. Chloride, Bromide oder Iodide des Aluminiums, Vanadiums oder Antimons.

Vorzugsweise beträgt die Menge an eingesetztem Katalysator berechnet als Metall 0,5 bis 10 Gew.-%, insbesondere bevorzugt 1 bis 5 Gew.-%, bezogen auf die Menge an eingesetztem Silicium.

Alternativ kann im erfindungsgemäßen Verfahren bei der Umsetzung zu Trichlorsilan (Schritt a)) auch metallurgisches Silicium mit einem Eisengehalt von 1 bis 10 Gew.-%, bevorzugt von 1 bis 5 Gew.-% eingesetzt werden, bei dem Eisen weitgehend homogen im metallurgischen Silicium verteilt ist, vorzugsweise in Form eines Silicids.

Das Silicium, das homogen verteiltes Eisen enthält, kann beispielsweise dadurch hergestellt werden, dass eine Mischung aus Silicium und der gewünschten Menge Eisen aufgeschmolzen wird bzw. einer Siliciumschmelze Eisen in der gewünschten Menge beigegeben wird und die Schmelze anschließend schnell abgekühlt wird. Vorzugsweise erfolgt die Zugabe der gewünschten Menge an Eisen bereits bei der Herstellung des Siliciums.

Die schnelle Abkühlung der Schmelze kann beispielsweise durch Verdüsen der Schmelze in Luft oder durch Wassergranulation erfolgen.

Bevorzugt wird zur schnellen Abkühlung einer Siliciumschmelze und damit zur Herstellung des einzusetzenden Siliciums die Wassergranulation eingesetzt. Bei der Wassergranulation wird flüssiges Silicium in Wasser eingetragen. Hierdurch kühlt das Silicium extrem schnell ab. Durch Wahl der Verfahrensparameter können beispielsweise Silicium-Pellets erhalten werden. Die Wassergranulation von Silicium ist beispielsweise aus EP 522 844 A2 bekannt.

Das Eisen liegt dann fein und homogen verteilt im Silicium vor.

Das Molverhältnis von Wasserstoff zu Siliciumtetrachlorid kann in Schritt a) des erfindungsgemäßen Verfahrens beispielsweise 0,25:1 bis 4:1 betragen. Bevorzugt ist ein Molverhältnis von 0,6:1 bis 2:1.

Der bei der Umsetzung von metallurgischem Silicium mit SiCl₄, H₂ und HCl (Schritt a)) entstehende trichlorsilanhaltige Rohgasstrom wird erfindungsgemäß durch Wäsche mit kondensierten Chlorsilanen bei einem Druck von 25 bis 40 bar, vorzugsweise von 35 bis 40 bar und einer Temperatur von 160 bis 220°C, vorzugsweise von 190 bis 200°C in einer mehrstufigen Destillationskolonne gereinigt (Schritt b)).

Als kondensierte Chlorsilane eignet sich beispielsweise ein kondensierter Gasstrom, bestehend aus Trichlorsilan und Siliciumtetrachlorid im Molverhältnis von etwa 1 : 3 bis 1 : 20

Es wurde überraschend gefunden, dass bei Einhaltung des genannten Temperaturund Druckbereiches die gegebenenfalls im trichlorsilanhaltigen Rohgasstrom enthaltenen Siliciumstaubreste und Metallchloride, insbesondere auch AlCl₃ aus dem Rohgasstrom komplett abgetrennt werden und mit den kondensierten Chlorsilanen aus der Waschkolonne als Feststoffe oder als gelöstes Metallchlorid (z.B. AlCl₃) entfernt werden können.

Die oben geschilderten Probleme, die durch Sublimation von AlCl₃ in der Waschkolonne verursacht werden, werden bei der erfindungsgemäßen Vorgehensweise sicher vermieden. Dies ermöglicht einen störungsfreien lang andauernden Betrieb der Waschkolonne und damit des gesamten Prozesses. Mit den kondensierten Chlorsilanen werden auch gegebenenfalls vorhandene höher siedende Substanzen wie Disilane, Polysilane, Siloxane und Kohlenwasserstoffe aus dem Rohgasstrom entfernt.

Es fällt eine Chlorsilane-Suspension an, die anschließend entspannt und abgekühlt werden kann, wobei gelöste Metallchloride, insbesondere AlCl₃ weitgehend bis auf wenige ppm ausfallen.

Vorzugsweise wird die Chlorsilane-Suspension nach Entspannung und Abkühlung durch Filtration von Feststoffen befreit. Die feststofffreien Chlorsilane können einer Verwertung zugeführt und die abgetrennten Feststoffe mit Alkaliverbindungen behandelt werden.

Die Filtration der Chlorsilane-Suspension erfolgt vorzugsweise über Sintermetall-Filtermaterialien. Derartige Filter sind bekannt und beispielsweise in "Ullmanns Encyklopädie der technischen Chemie, 4. Aufl., Bd. 19, S. 573, Verlag Chemie, 1980" beschrieben.

Das feststofffreie Filtrat eignet sich hervorragend als Rohstoff für die Herstellung von pyrogener Kieselsäure. Eine weitere Aufarbeitung, beispielsweise durch Destillation ist nicht erforderlich. Der bei der Filtration anfallende Feststoff kann in bekannter Weise mit Alkaliverbindungen wie beispielsweise Natronlauge, Na₂CO₃, NaHCO₃ und CaO inertisiert und nach der Inertisierung als Rohstoff bei der Zementherstellung eingesetzt werden.

In einer vorteilhaften Variante des erfindungsgemäßen Verfahrens wird das trichlorsilanhaltige Rohgas vor der Wäsche mit kondensierten Chlorsilanen durch Gasfiltration von gegebenenfalls vorhandenen staubförmigen Feststoffen befreit. Hierfür eigenen sich beispielsweise Zyklone, wobei zum Erreichen von hohen Abscheidungsgraden mehrere hintereinander geschaltete Zyklone und/oder ein oder mehrere Multizyklone eingesetzt werden können. Alternativ dazu können auch Heißgasfilter mit Sintermetall- oder Keramikkerzen oder Kombinationen von Zyklonen und Heißgasfiltern eingesetzt werden. Diese Vorgehensweise hat den Vorteil, dass die nachfolgende Rohgaswäsche deutlich entlastet wird und ein siliciummetallhaltiger Feststoff erhalten wird, der aufgrund seines hohen Gehaltes an Silicium einer Verwertung in metallurgischen Prozessen wie beispielsweise der Herstellung von Eisenlegierungen zugeführt werden kann. Dazu kann der siliciummetall- und metallchloridhaltige Feststoff beispielsweise mit Alkaliverbindungen wie Natronlauge, Na₂CO₃, NaHCO₃ und CaO und Wasser umgesetzt, filtriert und zur Entfernung von Chlorid mit Wasser gewaschen und gegebenenfalls getrocknet werden.

Der nunmehr gereinigte Rohgasstrom wird in bekannter Weise kondensiert und durch vorzugsweise mehrstufige Destillation in einen vorwiegend SiCl₄ enthaltenden Teilstrom und einen vorwiegend SiHCl₃ enthaltenden Teilstrom aufgetrennt.

Vorzugsweise wird der vorwiegend SiCl₄ enthaltende Teilstrom in die Umsetzung von metallurgischem Silicium mit Siliciumtetrachlorid, H₂ und HCl (Schritt a)) rückgeführt.

Die Destillation kann bei einem Druck von 1 bis 40 bar durchgeführt werden. Vorzugsweise wird die Destillation bei einem Druck unterhalb von 10 bar durchgeführt, um eine möglichst gute Trennung von SiCl₄ und SiHCl₃ mit einer minimalen Anzahl von Destillations-Stufen zu erreichen.

Der SiHCl₃-haltige Teilstrom wird erfindungsgemäß einer nachfolgenden Disproportionierung zugeführt. Es hat sich als vorteilhaft erwiesen diesen Teilstrom in einer mehrstufigen Destillation weitestgehend von gegenüber SiHCl₃ leichter siedenden Komponenten zu befreien. Diese Destillation kann ebenfalls bei einem Druck von 1 bis 40 bar durchgeführt werden. Vorzugsweise wird die Destillation bei einem Druck unterhalb von 10 bar durchgeführt, um eine möglichst gute Abtrennung leichter siedender Verbindungen aus SiHCl₃ mit einer minimalen Anzahl von Stufen zu erreichen.

In einer weiteren vorteilhaften Variante wird das gereinigte SiHCl₃ anschließend durch Kontakt mit basischen Feststoffen von Anhydrosäuren wie Halogeniden und Hydriden befreit. Beispiele für Anhydrosäuren sind BCl₃, BH₃, PCl₃, HCl. Dies hat den Vorteil, dass die Wirksamkeit der nachfolgenden katalysierten Disproportionierung nicht beeinträchtigt wird und damit ein lang andauernder störungsfreier Betrieb der Disproportionierung möglich wird. Die eingesetzten basischen Feststoffe können mit den im nächsten Schritt eingesetzten Disproportionierungskatalysatoren identisch sein.

Die Kontaktierung mit basischen Feststoffen kann z.B. in einem Festbettreaktor durchgeführt werden. Es wird vorzugsweise bei einem Druck von 1 bis 50 bar gearbeitet, besonders bevorzugt zwischen 1 und 10 bar. Die Temperaturen können beispielsweise zwischen 30 und 180°C liegen, vorzugsweise zwischen 50 und 110°C. Die einzustellende Temperatur richtet sich nach dem Stabilitätsbereich der eingesetzten basischen Feststoffe. Um einen kontinuierlichen Betrieb zu gewährleisten, können zwei oder mehr mit basischem Feststoff versehene Reaktoren parallel geschaltet sein. In regelmäßigen Abständen kann auf einen mit frischem Feststoff versehenen Reaktor umgeschaltet werden, um die vollständige Entfernung der oben genannten Verunreinigungen zu garantieren, während der verbrauchte Feststoff ausgetauscht und gegebenenfalls regeneriert wird. Ebenso kann ein Reaktor durch eine Hintereinanderschaltung mehrerer Reaktoren ausgeführt werden.

Die Disproportionierung des gegebenenfalls gereinigten trichlorsilanhaltigen Teilstroms (Schritt c)) wird besonders bevorzugt in einer Kolonne bei einem Druck von 1 bis 10 bar durchgeführt, wobei die Kolonne mindestens zwei reaktiv/destillative Reaktionsbereiche aufweist.

Die Disproportionierung erfolgt dabei an katalytisch wirkenden Feststehen, bevorzugt in Katalysatorbetten, die jeweils aus einer für die Disproportionierungsprodukte durchströmbaren Schüttgutschicht aus Festkörpern aus den katalytisch wirksamen Feststoffen bestehen. Statt einer Schüttgutschicht können im Reaktionsbereich auch gepackte Katalysatorkörper vorgesehen sein.

Geeignete katalytisch wirksame Feststoffe sind bekannt und beispielsweise in der DE 2 507 864 A1 beschrieben. Es sind beispielsweise solche Feststoffe geeignet, die an einem Gerüst aus Polystyrol, vernetzt mit Divinylbenzol, Amino- oder Alkylenamino-Gruppen tragen. Als Amino- oder Alkylenamino-Gruppen seien beispielsweise genannt: Dimethylamino-, Diethylamino-, Ethylmethylamino-, Di-n-propylamino-, Di-iso-propylamino-, Di-2-chlorethylamino-, Di-2-chlorpropylamino-Gruppen sowie die gleichartig substituierten Dialkylaminomethylen-Gruppen und die entsprechenden Hydrochloride oder aber die durch Methylierung, Ethylierung, Propylierung, Butylierung, Hydroxyethylierung oder Benzylierung daraus gebildeten Trialkylammonium-Gruppen mit Chlorid als Gegenion. Selbstverständlich können im Fall quartärer Ammoniumsalze oder protonierter Ammoniumsalze auch katalytisch wirksame Feststoffe mit anderen Anionen, z.B. Hydroxid, Sulfat, Hydrogensulfat, Bicarbonat u.a. in das erfindungsgemäße Verfahren eingerührt werden, eine Umwandlung in die Chloridform ist unter den Reaktionsbedingungen mit der Zeit aber unvermeidbar, was auch für organische Hydroxygruppen gilt. Bevorzugt sind demnach solche Ammoniumsalze, die Chlorid als Gegenion enthalten.

Als katalytisch wirksame Feststoffe sind beispielsweise auch Feststoffe geeignet, die aus einem Polyacrylsäure-Gerüst, speziell einem Polyacrylamid-Gerüst bestehen, das z.B. über eine Alkylgruppe Trialkylbenzylammonium gebunden hat.

Eine andere geeignete Gruppe katalytisch wirksamer Feststoffe sind beispielsweise solche, die an einem Polystyrol-Gerüst, vernetzt mit Divinylbenzol, Sulfonat-Gruppen angebunden haben, denen als Kationen tertiäre oder quartäre Ammoniumgruppen gegenüberstehen.

Im Regelfall sind makroporöse oder mesoporöse Austauscherharze besser als Gelharze geeignet.

Der trichlorsilanhaltige Teilstrom aus Schritt b) wird der Reaktionskolonne über einen Zulauf zugeführt, der in die Kolonne an geeigneter Stelle mündet. Eine geeignete Stelle ist beispielsweise eine Stelle, an der die Kolonne in ihrem Inneren eine Temperatur aufweist, die dem Siedepunkt des Trichlorsilans unter dem herrschenden Druck entspricht. In den Reaktionsbereichen wird durch Disproportionierung von SiHCl₃ ein SiH₄-haltiges, im Reaktionsbereich aufsteigendes dampfförmiges Produktgemisch, und ein SiCl₄ enthaltendes, im Reaktionsbereich abströmendes Flüssigkeitsgemisch gebildet.

Die aus dem Reaktionsbereich austretende SiCl₄ enthaltende Flüssigkeit wird in der Reaktionskolonne in einen unterhalb des reaktiv/destillativen Bereiches angeordneten destillativen Abtriebsteil eingeführt, aus dem als Sumpfprodukt Siliciumtetrachlorid SiCl₄ abfließen kann.

Für das im Reaktionsbereich aufsteigende SiH₄-haltige Produktgemisch ist oberhalb der Reaktionsbereiche ein Zwischenkondensator vorgesehen, in dem durch Teilkondensation von schwerer siedenden Komponenten bei einer Temperatur zwischen -25°C und 50°C, bevorzugt zwischen -5°C und 40°C, die Konzentration von SiH₄ im Produktgemisch erhöht wird. Die im Zwischenkondensator nicht kondensierten, leichter siedenden Produktanteile werden zur weiteren Konzentrationserhöhung einem dem Zwischenkondensator in Strömungsrichtung der aufsteigenden Produktanteile nachgeschalteten zweiten reaktiv/destillativen Reaktionsbereich und anschließend einem Verstärkerteil zugeführt.

Bevorzugt wird die Disproportionierung so durchgeführt, dass in den Reaktionsbereichen insgesamt mehrere Zwischenkondensationen auf unterschiedlichen Temperaturniveaus im Bereich -25°C bis 50°C vorgenommen werden.

Die Verwendung von drei oder mehreren reaktiv/destillativen Reaktionsbereichen und von zwei oder mehreren Zwischenkondensatoren bietet die Möglichkeit, die Zwischenkondensationswärme auf verschiedenen Temperaturniveaus mit geringen treibenden Temperaturdifferenzen exergetisch vorteilhaft abzuführen.

Der Verstärkerteil kann innerhalb oder außerhalb der Reaktionskolonne angeordnet sein. Das aus dem Verstärkerteil abziehende Produktgemisch wird schließlich in einen Kopfkondensator geleitet, dort niedergeschlagen und abgeführt. Ein Teil des Produktgemischs kann zum Kopf der Reaktionskolonne zurückgeführt werden.

Auf verschiedenen Temperaturniveaus in der Reaktionskolonne sich ansammelnde Verunreinigungen können gegebenenfalls durch seitliche Entnahmestellen aus der Kolonne entnommen werden.

Zur weiteren Absenkung der bei sehr niedriger Temperatur abzuführenden Kondensationsenergie kann die Rücklaufmenge vermindert und ein Kopfprodukt mit geringerer Silanreinheit zwischen 25 % bis 90 % erzeugt werden. Dieses Kopfprodukt kann dann zur weiteren Reinigung in einer nachgeschalteten Trennkolonne getrennt werden, wobei ein gleicher oder vorzugsweise höherer Druck als in der Reaktionskolonne, vorzugsweise 15 bar bis 100 bar, eingestellt ist, so dass die Trennkolonne folglich bei höheren Temperaturen, bezogen auf gleiche Zusammensetzung, arbeitet als die Reaktionskolonne. Das Sumpfprodukt der Trennkolonne kann abhängig von den gewählten Betriebsbedingungen große Anteile Trichlorsilan, Dichlorsilan und Monochlorsilan enthalten. Das Sumpfprodukt kann ganz oder teilweise in die Reaktionskolonne zurückgeführt werden. Durch Ausschleusen eines Teilstroms können gegebenenfalls Verunreinigungen aus dem System entfernt werden.

Bevorzugt wird das bei der Disproportionierung erhaltene SiCl₄ in die Umsetzung von Silicium mit SiCl₄, H2 und HCl (Schritt a)) rückgeführt.

Erfindungsgemäß wird das bei der Disproportionierung erhaltene SiH₄ thermisch zersetzt (Schritt d)).

Es ist möglich, das bei der Disproportionierung erhaltene SiH₄ vor dessen thermischer Zersetzung einer destillativen Reinigung zu unterziehen.

In einer besonders bevorzugten Ausführungsform des erfindungsgemäßen Verfahrens wird die thermische Zersetzung des gegebenenfalls durch Destillation gereinigten SiH₄ an Reinstsilicium-Keimpartikeln im Wirbelbett bei einem Druck von 100 bis 900 mbar durchgeführt.

Die thermische Zersetzung wird bevorzugt bei Drucken von 200 bis 800 mbar durchgeführt. Besonders bevorzugt ist der Druckbereich 300 bis 700 mbar, insbesondere bevorzugt 400 bis 600 mbar. Alle angegebenen Druckwerte sind absolute Druckwerte. Unter dem genannten Druck ist dabei der Druck zu verstehen, der, in Strömungsrichtung des zugeführten Gasstroms gesehen, hinter der Wirbelschicht herrscht.

Es ist möglich, bei der thermischen Zersetzung des Silans bis zu 50 Vol-% eines siliziumfreien Gases, bezogen auf das insgesamt zugeführte Gas, zuzusetzen. Vorzugsweise beträgt die zugesetzte Menge an siliziumfreiem Gas 0 bis 40 Vol-%, besonders bevorzugt 0 bis 20 Vol-%. Der Zusatz des siliziumfreien Gases verringert die Bildung von Siliziumstaub.

Geeignete siliziumfreie Gase sind beispielsweise die Edelgase, Stickstoff und Wasserstoff, wobei die siliziumfreien Gase einzeln oder in beliebiger Kombination eingesetzt werden können. Bevorzugt sind Stickstoff und Wasserstoff, besonders bevorzugt ist Wasserstoff.

Der vorteilhafte Temperaturbereich bei der thermischen Zersetzung des Silans liegt zwischen 500°C und 1400°C. Bevorzugt ist eine Zersetzungstemperatur von 600°C bis 1000°C, besonders bevorzugt 620°C bis 700°C.

Die Reinstsilicium-Keimpartikeln können im Reaktionsraum eines Wirbelschichtreaktors vorgelegt werden. Die Reinstsilicium-Keimpartikel können absatzweise oder auch kontinuierlich von außen zugeführt werden. Als Reinstsilicium-Keimpartikeln können jedoch auch solche Partikel Verwendung finden, die im Reaktionsraum generiert werden. Die Reinstsilicium-Keimpartikel bilden dabei ein Festbett, durch das das zugeführte Gas eingeströmt wird. Die Einströmgeschwindigkeit des zugeführten Gases wird so eingestellt, dass das Festbett fluidisiert wird und sich eine Wirbelschicht ausbildet. Die entsprechende Vorgehensweise ist dem Fachmann an und für sich bekannt. Die Einströmgeschwindigkeit des zugeführten Gases muss mindestens der Lockerungsgeschwindigkeit entsprechen. Unter Lockerungsgeschwindigkeit wird dabei die Geschwindigkeit verstanden, mit der ein Gas durch ein Bett aus Partikeln strömt und unterhalb derer das Festbett erhalten bleibt, d.h. unterhalb derer die Bettpartikel weitgehend unbewegt bleiben. Oberhalb dieser Geschwindigkeit beginnt die Fluidisierung des Betts, d.h. die Bettpartikel bewegen sich und es bilden sich erste Blasen.

Die Einströmgeschwindigkeit des zugeführten Gases beträgt bei dieser bevorzugten Ausführungsform die ein- bis zehnfache, bevorzugt die eineinhalb- bis siebenfache Lockerungsgeschwindigkeit.

Vorteilhaft werden Reinstsilicium-Keimpartikel eingesetzt, die einen Durchmesser von 50 bis 5000 µm aufweisen.

Die Reinstsilicium-Keimpartikel können beispielsweise durch Zerkleinerung von den bei der thermischen Zersetzung von SiH₄ im Wirbelbett entstehenden Reinstsilicium-Granalien erzeugt werden. Bei den üblichen Zerkleinerungsverfahren, beispielsweise Mahlung, besteht die Gefahr, dass die Reinstsilicium-Keimpartikel während der Zerkleinerung verunreinigt werden.

Der Herstellung der Reinstsilicium Keimpartikel erfolgt daher vorzugsweise durch Erzeugung im Zersetzungreaktor selbst, Abtrennen einer Fraktion geeigneter Partikelgröße durch prozessinterne Sichtung und deren Rückführung in den Reaktor.

Bevorzugt wird der bei der thermischen Zersetzung von Silan gebildete Wasserstoff in die Umsetzung von Silicium mit SiCl₄, H₂ und HCl (Schritt a)) rückgeführt.

In einer weiteren bevorzugten Variante wird der bei der thermischen Zersetzung von SiH₄ als Nebenprodukt anfallende Reinstsilicium-Staub nach Abtrennung von den Reinstsilicium-Granalien in einem separaten Verfahrensschritt durch Einwirkung von Mikrowellenstrahlung im Wellenlängenbereich von 0,5 kHz bis 300 GHz auf eine Temperatur von mindestens 300°C erhitzt und agglomeriert. Dabei wird ein Produkt erhalten, das beispielsweise ohne weitere Aufarbeitungsschritte wie Verdichtung und Zerkleinerung in den Schmelzprozess für die Herstellung von Siliciumwafern für Solarzellen eingesetzt werden kann.

Eine weitere bevorzugte Auführungsform des erfindungsgemäßen Verfahrens sieht vor, dass SiH₄- und SiH₂Cl₂-haltige Abfallströme der verschiedenen Destillationen gesammelt und mit SiCl₄ zu einem SiHCl₃-haltigen Reaktionsgemsich umgesetzt werden, aus dem SiHCl₃ durch Destillation gewonnen wird. Es ist vorteilhaft, dass bei dieser Umsetzung flüssige Disproportionierungskatalysatoren mit einem Siedepunkt eingesetzt werden, der höher als der Siedepunkt von SiCl₄ ist. Geeignete Disproportionierungskatalysatoren sind beispielsweise Trialkylamine und Aryldialkylamine.

Das gewonnene SiHCl₃ kann gegebenenfalls nach weiterer Reinigung bei der Disproportionierung (Schritt c)) eingesetzt werden. Damit wird die Ausbeute und die Wirtschaftlichkeit des Gesamtprozesses verbessert, weil eine Entsorgung der genannten Abfallströme verbunden mit dem Verlust der Siliciumverbindungen entfällt.

Das erfindungsgemäß erhältliche Reinstsilicium kann aufgrund seiner hohen Reinheit problemlos als Rohstoff bei der Herstellung von Halbleitern und Solarzellen eingesetzt werden.

Durch die erfindungsgemäß mögliche Nutzung der Abfallströme und Nebenprodukte, durch höhere Ausbeuten bei der SiHCl₃-Synthese und durch den insgesamt deutlich geringeren Energiebedarf ermöglicht das erfindungsgemäße Verfahren eine sehr kostengünstige Herstellung von Reinstsilicium.

## Patentansprüche

1. Verfahren zur Herstellung von Reinstsilicium **gekennzeichnet durch** die Schritte:
a) Umsetzung von metallurgischem Silicium mit Siliciumtetrachlorid (SiCl₄), Wasserstoff (H₂) und Chlorwasserstoff (HCl) bei einer Temperatur von 500 bis 800°C und einem Druck von 25 bis 40 bar zu einem trichlorsilanhaltigen (SiHCl₃) Rohgasstrom,
b) Entfernung von Verunreinigungen aus dem entstehenden trichlorsilanhaltigen Rohgasstrom **durch** Wäsche mit kondensierten Chlorsilanen bei einem Druck von 25 bis 40 bar und einer Temperatur von 160 bis 220°C in einer mehrstufigen Destillationskolonne, wobei ein gereinigter trichlorsilanhaltiger Rohgasstrom und eine feststoffhaltige Chlorsilane-Suspension entstehen und destillative Auftrennung des gereinigten Rohgasstroms in einen im wesentlichen aus SiCl₄ und einen im wesentlichen aus SiHCl₃ bestehenden Teilstrom,
c) Disproportionierung des SiHCl₃-haltigen Teilstroms zu SiCl₄ und SiH₄, wobei die Disproportionierung in mehreren reaktiv/destillativen Reaktionsbereichen, die im Gegenstrom von Dampf und Flüssigkeit durchströmt werden, an katalytisch wirkenden Feststoffen unter einem Druck von 500 mbar bis 50 bar durchgeführt wird und wobei einem ersten Reaktionsbereich SiHCl₃ zugeführt wird, das dort erzeugte leichter siedende SiH₄-haltige Disproportionierungs-Produkt im Temperaturbereich von -25°C bis 50°C zwischenkondensiert wird, das dabei nicht kondensierte SiH₄-haltige Produktgemisch in einem oder mehreren weiteren reaktiv/destillativen Reaktionsbereichen geführt wird, und das erzeugte leichter siedende, hohe Anteile an SiH₄ enthaltende Produkt im Kopfkondensator teilweise oder vollständig kondensiert wird, und
d) thermische Zersetzung des SiH₄ zu Reinstsilicium.

2. Verfahren gemäß Anspruch 1, **dadurch gekennzeichnet, dass** Schritt a) in einem Wirbelbettreaktor durchgeführt wird.

3. Verfahren gemäß mindestens einem der Ansprüche 1 bis 2, **dadurch gekennzeichnet, dass** Chlorwasserstoff in einer Menge von 0,05 bis 10 Gew.-%, bezogen auf die Masse des zugeführten SiCl₄ eingebracht wird.

4. Verfahren gemäß mindestens einem der Ansprüche 1 bis 3, **dadurch gekennzeichnet, dass** Schritt a) in Gegenwart eines Katalysators durchgeführt wird, wobei der Katalysator und das metallurgische Silicium vor der Zugabe in einen Reaktor intensiv vermischt werden.

5. Verfahren gemäß Anspruch 4, **dadurch gekennzeichnet, dass** als Katalysator Kupfer, Eisen, Kupferverbindungen, Eisenverbindungen oder deren Mischungen eingesetzt werden.

6. Verfahren gemäß mindestens einem der Ansprüche 1 bis 3, **dadurch gekennzeichnet, dass** metallurgisches Silicium mit einem Eisengehalt von 0,5 bis 10 Gew.-% eingesetzt wird, bei dem Eisen weitgehend homogen im metallurgischen Silicum verteilt ist.

7. Verfahren gemäß mindestens einem der Ansprüche 1 bis 6, **dadurch gekennzeichnet, dass** gegebenenfalls vorhandene feste Bestandteile des trichlorsilanhaltigen Rohgasstroms vor der Wäsche mit kondensierten Chlorsilanen abgetrennt werden.

8. Verfahren gemäß mindestens einem der Ansprüche 1 bis 7, **dadurch gekennzeichnet, dass** die in Schritt b) entstehende feststoffhaltige Chlorsilane-Suspension durch Filtration von Feststoffen befreit wird, die feststofffreien Chlorsilane einer Verwertung zugeführt werden und die Feststoffe mit Alkaliverbindungen behandelt werden.

9. Verfahren gemäß Anspruch 8, **dadurch gekennzeichnet, dass** die Filtration mit Sintermetall-Filtermaterialien durchgeführt wird.

10. Verfahren gemäß mindestens einem der Ansprüche 1 bis 9, **dadurch gekennzeichnet, dass** der in Schritt b) gewonnene SiCl₄-haltige Teilstrom in die Umsetzung von metallurgischem Silicium mit SiCl₄, H₂ und HCl (Schritt a)) rückgeführt wird.

11. Verfahren gemäß mindestens einem der Ansprüche 1 bis 10, **dadurch gekennzeichnet, dass** der in Schritt b) gewonnene im wesentlichen aus Trichlorsilan bestehende Teilstrom vor der Disproportionierung in einer mehrstufigen Destillation weitestgehend von gegenüber SiHCl₃ leichter siedenden Komponenten befreit wird.

12. Verfahren gemäß mindestens einem der Ansprüche 1 bis 11, **dadurch gekennzeichnet, dass** zur Entfernung von Anhydrosäuren wie Halogeniden und Hydriden aus dem in Schritt b) gewonnenen im wesentlichen aus Trichlorsilan bestehende Teilstrom dieser Teilstrom vor der Disproportionierung mit basischen Feststoffen in Berührung gebracht wird.

13. Verfahren gemäß mindestens einem der Ansprüche 1 bis 12, **dadurch gekennzeichnet, dass** die Disproportionierung von Trichlorsilan (Schritt c)) bei einem Druck von 1 bis 10 bar durchgeführt wird.

14. Verfahren gemäß mindestens einem der Ansprüche 1 bis 13, **dadurch gekennzeichnet, dass** in Schritt c) in den Reaktionsbereichen insgesamt mehrere Zwischenkondensationen auf unterschiedlichen Temperaturniveaus im Bereich von -25°C bis 50°C vorgenommen werden.

15. Verfahren gemäß mindestens einem der Ansprüche 1 bis 14, **dadurch gekennzeichnet, dass** das in Schritt c) erhaltene SiCl₄ in die Umsetzung von metallurgischem Silicium mit SiCl₄, H₂ und HCl (Schritt a)) rückgeführt wird.

16. Verfahren gemäß mindestens einem der Ansprüche 1 bis 15, **dadurch gekennzeichnet, dass** das in Schritt c) gebildete SiH₄ vor der thermischen Zersetzung einer destillativen Reinigung unterzogen wird.

17. Verfahren gemäß mindestens einem der Ansprüche 1 bis 16, **dadurch gekennzeichnet, dass** silan- und dichlorsilanhaltige Abfallströme der Destillationsschritte gesammelt werden und mit SiCl₄ zu einem trichlorsilanhaltigen Reaktionsgemisch umgesetzt werden, und aus diesem Reaktionsgemisch SiHCl₃ durch Destillation gewonnen wird.

18. Verfahren gemäß Anspruch 17, **dadurch gekennzeichnet, dass** bei der Umsetzung der silan- und dichlorsilanhaltigen Abfallströme mit SiCl₄ flüssige Disproportionierungskatalysatoren mit einem Siedepunkt eingesetzt werden, der höher als der Siedepunkt von SiCl₄ ist.

19. Verfahren gemäß mindestens einem der Ansprüche 1 bis 18, **dadurch gekennzeichnet, dass** die thermische Zersetzung von SiH₄ (Schritt d)) an Reinstsilicium-Saatpartikeln im Wirbelbett bei einem Druck von 100 bis 900 mbar durchgeführt wird.

20. Verfahren gemäß mindestens einem der Ansprüche 1 bis 19, **dadurch gekennzeichnet, dass** bei der thermischen Zersetzung von SiH₄ zusätzlich zum SiH₄ aus Schritt c) bis zu 50 Vol-% eines siliciumfreien Gases, bezogen auf die Gesamtmenge des zugeführten Gases zugegeben werden.

21. Verfahren gemäß Anspruch 20, **dadurch gekennzeichnet, dass** als siliciumfreies Gas Wasserstoff verwendet wird.

22. Verfahren gemäß mindestens einem der Ansprüche 1 bis 21, **dadurch gekennzeichnet, dass** der in Schritt d) gebildete H₂ in die Umsetzung von metallurgischem Silicium mit SiCl₄, H₂ und HCl (Schritt a)) rückgefuhrt wird.

23. Verfahren gemäß mindestens einem der Ansprüche 1 bis 22, **dadurch gekennzeichnet, dass** bei der thermischen Zersetzung von gereingtem SiH₄ (Schritt d)) als Nebenprodukt Reinstsiliciumstaub entsteht, der durch Einwirkung von Mikrowellenstrahlung im Wellenlängenbereich von 0,5 kHz bis 300 GHz auf eine Temperatur von mindestens 300°C erhitzt und agglomeriert wird.

24. Verfahren zur Herstellung von Solarzellen mit folgenden Verfahrensschritten:
- Herstellen von Reinstsilicium nach einem der Ansprüche 1 bis 23,
- Weiterverarbeiten des hergestellten Reinstsiliciums zu Solarzellen.

## Claims

1. A method for producing high-purity silicon, **characterised by** the following steps:
a) reaction of metallic silicon with silicon tetrachloride (SiCl₄), hydrogen (H₂) and hydrochloric acid (HCl) at a temperature of 500 to 800°C and a pressure of 25 to 40 bar to give a trichlorosilane-containing (SiHCl₃) feed gas stream,
b) removal of impurities from the resultant trichlorosilane-containing feed gas stream by scrubbing with condensed chlorosilanes at a pressure of 25 to 40 bar and a temperature from 160 to 220°C in a multi-stage distillation column, to give a purified trichlorosilane-containing feed gas stream and a solid-containing chlorosilane suspension, and distillative separation of the purified feed gas stream into a partial stream essentially comprising SiCl₄ and a partial stream essentially comprising SiHCl₃,
c) disproportionation of the SiHCl₃-containing partial stream to give SiCl₄ and SiH₄, whereby the disproportionation is carried out in several reactive/distillative reaction zones, with a counter-current of vapour and liquid, on catalytically active solids at a pressure of 500 mbar to 50 bar and SiHCl₃ is introduced into a first reaction zone, the lower-boiling SiH₄-containing disproportionation product produced there undergoes an intermediate condensation in a temperature range of -25 to 50°C, the non-condensed SiH₄-containing product mixture is fed to one or more further reactive/distillative reaction zones and the lower boiling point product thus generated, containing a high proportion of SiH₄ is completely or partially condensed in the top condenser, and
d) thermal decomposition of the SiH₄ to give high-purity silicon.

2. A method according to Claim 1, **characterised in that** step a) is performed in a fluid bed reactor.

3. A method according to any of Claims 1 and 2, **characterised in that** hydrochloric acid is introduced at a quantity of 0.05 to 10 wt. % relative to the weight of the supplied SiCl₄.

4. A method according to any of Claims 1 through 3, **characterised in that** step a) is performed in the presence of a catalyst wherein said catalyst and the metallic silicon are thoroughly mixed prior to being fed into a reactor.

5. A method according to Claim 4, **characterised in that** copper, iron, copper compounds, iron compounds, or mixtures thereof are used as catalyst.

6. A method according to any of Claims 1 through 3, **characterised in that** metallic silicon having an iron content of 0.5 to 10 wt. % is used, wherein iron is mostly homogeneously distributed among the metallic silicon.

7. A method according to any of Claims 1 through 6, **characterised in that** solid components, if any, of the trichlorosilane-containing feed gas stream are separated prior to scrubbing with condensed chlorosilanes.

8. A method according to any of Claims 1 through 7, **characterised in that** the solid-containing chlorosilane suspension generated in step b) is made free of solids by filtration, the solid-free chlorosilanes are transferred to further utilisation, and the solids are treated with alkali compounds.

9. A method according to Claim 8, **characterised in that** filtration is performed using sinter metal filter materials.

10. A method according to any of Claims 1 through 9, **characterised in that** the SiCl₄-containing partial stream obtained in step b) is fed back into the reaction of metallic silicon with SiCl₄, H₂ and HCl (step a)).

11. A method according to any of Claims 1 through 10, **characterised in that** the partial stream consisting mostly of trichlorosilane obtained in step b) is made mostly free from components having a lower boiling point than SiHCl₃ prior to disproportionation.

12. A method according to any of Claims 1 through 11, **characterised in that** the partial stream consisting mostly of trichlorosilane obtained in step b) is brought into contact with caustic solids prior to disproportionation for the purpose of removing anhydric acids such as halogenides and hydrides.

13. A method according to any of Claims 1 through 12, **characterised in that** disproportionation of trichlorosilane (step c)) is performed at a pressure between 1 and 10 bar.

14. A method according to any of Claims 1 through 13, **characterised in that** in step c) several intermediate condensation processes at different temperature levels in the range from -25°C to 50°C are performed in the reaction zones as a whole.

15. A method according to any of Claims 1 through 14, **characterised in that** SiCl₄ obtained in step c) is fed back into the reaction of metallic silicon with SiCl₄, H₂ and HCl (step a)).

16. A method according to any of Claims 1 through 15, **characterised in that** SiH₄ generated in step c) is subjected to a distillative purification prior to its thermal decomposition.

17. A method according to any of Claims 1 through 16, **characterised in that** silane and dichlorosilane-containing waste streams of the distillation steps are collected to react with SiCl₄ to give a trichlorosilane-containing reaction mixture, with obtaining SiHCl₃ by distillation from said reaction mixture.

18. A method according to Claim 17, **characterised in that** in the reaction of the silane and dichlorosilane-containing waste streams with SiCl₄ liquid disproportionation catalysts having a boiling point above the boiling point of SiCl₄ are used.

19. A method according to any of Claims 1 through 18, **characterised in that** the thermal decomposition of SiH₄ (step d)) on high-purity silicon seed particles is performed in a fluid bed at a pressure of 100 to 900 mbar.

20. A method according to any of Claims 1 through 19, **characterised in that** in the thermal decomposition of SiH₄ up to 50 vol. % of a silicon-free gas, relative to the overall quantity of the supplied gas, is added in addition to the SiH₄ from step c).

21. A method according to Claim 20, **characterised in that** hydrogen is used as silicon-free gas.

22. A method according to any of claims 1 through 21, **characterised in that** H₂ generated in step d) is fed back into the reaction of metallic silicon with SiCl₄, H₂ and HCl (step a)).

23. A method according to any of Claims 1 through 22, **characterised in that** in the thermal decomposition of purified SiH₄ (step d)) high-purity silicon powder is generated as by-product which is heated up to a temperature of at least 300°C and agglomerated by means of microwave irradiation in a wavelength range between 0.5 kHz and 300 GHz.

24. Method for the production of solar cells according to the following method steps:
- producing high-purity silicon according to one of claims 1 to 23,
- processing of the produced high-purity silicon for producing solar cells.

## Revendications

1. Procédé de préparation de silicium très pur, **caractérisé par** les étapes qui consistent à:
a) faire réagir du silicium métallurgique avec du tétrachlorure de silicium (SiCl₄), de l'hydrogène (H₂) et du chlorure d'hydrogène (HCl) à une température de 500 à 800°C et sous une pression de 25 à 40 bars pour obtenir un écoulement de gaz brut qui contient du trichlorosilane (SiHCl₃),
b) éliminer les impuretés de l'écoulement de gaz brut qui contient du trichlorosilane ainsi obtenu, par lavages avec des chlorosilanes condensés, sous une pression de 25 à 40 bars et à une température de 160 à 220°C dans une colonne de distillation à plusieurs étages, ce qui fournit un écoulement de gaz brut purifié qui contient du trichlorosilane et une suspension de chlorosilanes qui contient des solides, et séparer par distillation l'écoulement purifié de gaz brut en un écoulement partiel essentiellement constitué de SiCl₄ et un écoulement partiel essentiellement constitué de SiHCl₃,
c) disproportionner en SiCl₄ et SiH₄ l'écoulement partiel qui contient du SiHCl₃, la disproportionation étant exécutée dans différentes zones de réaction et de distillation qui sont traversées à contre-courant par de la vapeur et du liquide qui passent sur des solides à action catalytique, sous une pression de 500 mbars à 50 bars, du SiHCl₃ étant apporté à une première zone de réaction, le produit de disproportionation très volatil ainsi créé et qui contient du SiH₄ étant condensé temporairement dans une plage de température de -25°C à 50°C, le mélange de produits contenant du SiH₄ non condensé à cette occasion étant apporté dans une ou plusieurs autres zones de réaction ou de distillation, le produit ainsi créé, fortement volatil et qui contient une forte teneur en SiH₄ étant condensé partiellement ou complètement dans le condenseur de tête et
d) décomposer thermiquement le SiH₄ pour obtenir du silicium très pur.

2. Procédé selon la revendication 1, **caractérisé en ce que** l'étape a) est réalisée dans un réacteur à lit fluidisé.

3. Procédé selon au moins l'une des revendications 1 à 2, **caractérisé en ce que** le chlorure d'hydrogène est apporté en quantité de 0,05 à 10 % en poids par rapport à la masse de SiCl₄ apportée.

4. Procédé selon au moins l'une des revendications 1 à 3, **caractérisé en ce que** l'étape a) est réalisée en présence d'un catalyseur, le catalyseur et le silicium métallurgique étant mélangés intimement avant d'être apportés dans un réacteur.

5. Procédé selon la revendication 4, **caractérisé en ce que** comme catalyseur, on utilise du cuivre, du fer, des composés de cuivre, des composées de fer ou leurs mélanges.

6. Procédé selon au moins l'une des revendications 1 à 3, **caractérisé en ce que** le silicium métallurgique utilisé présente une teneur en fer de 0,5 à 10 %, le fer étant réparti dans le silicium métallurgique de manière très largement homogène.

7. Procédé selon au moins l'une des revendications 1 à 6, **caractérisé en ce que** des composants solides éventuellement présents dans l'écoulement de gaz brut qui contient du trichlorosilane sont séparés avant les lavages aux chlorosilanes condensés.

8. Procédé selon au moins l'une des revendications 1 à 7, **caractérisé en ce que** la suspension de chlorosilanes qui contient des solides, qui est produite à l'étape b), est débarrassée de ses solides par filtration, les chlorosilanes débarrassés des solides étant recyclés et les solides étant traités à l'aide de composés de métaux alcalins.

9. Procédé selon la revendication 8, **caractérisé en ce que** la filtration est réalisée avec des matériaux de filtre en métal fritté.

10. Procédé selon au moins l'une des revendications 1 à 9, **caractérisé en ce que** l'écoulement partiel qui contient du SiCl₄ et qui est obtenu à l'étape b) est renvoyé dans la réaction du silicium métallurgique avec SiCl₄, H₂ et HCl (étape a)).

11. Procédé selon au moins l'une des revendications 1 à 10, **caractérisé en ce que** par distillation en plusieurs étapes, l'écoulement partiel essentiellement constitué de trichlorosilane et obtenu dans l'étape b) est très largement débarrassé des composants plus volatils que le SiHCl₃ avant la disproportionation.

12. Procédé selon au moins l'une des revendications 1 à 11, **caractérisé en ce que** pour éliminer les anhydrides d'acide tels que des halogénures et des hydrures dans l'écoulement partiel essentiellement constitué de trichlorosilanes et récupéré dans l'étape b), cet écoulement partiel est amené en contact avec des solides basiques avant la disproportionation.

13. Procédé selon au moins l'une des revendications 1 à 12, **caractérisé en ce que** la disproportionation du chlorosilane (étape c)) est réalisée sous une pression de 1 à 10 bars.

14. Procédé selon au moins l'une des revendications 1 à 13, **caractérisé en ce que** dans l'étape c), on réalise globalement dans les zones de réaction plusieurs condensations intermédiaires à différents niveaux de température situés dans la plage de -25°C à 50°C.

15. Procédé selon au moins l'une des revendications 1 à 14, **caractérisé en ce que** le SiCl obtenu à l'étape c) est renvoyé dans la réaction du silicium métallurgique avec SiCl₄, H₂ et HCl (étape a)).

16. Procédé selon au moins l'une des revendications 1 à 15, **caractérisé en ce que** le SiH₄ produit dans l'étape c) subit une purification par distillation avant sa décomposition thermique.

17. Procédé selon au moins l'une des revendications 1 à 16, **caractérisé en ce que** des écoulements de rejet qui contiennent du silane et du dichlorosilane de l'étape de distillation sont rassemblés et **en ce qu'**on les fait réagir avec du SiCl₄ pour obtenir un mélange de réaction qui contient du trichlorosilane, du SiHCl₃ étant récupéré par distillation de ce mélange de distillation.

18. Procédé selon la revendication 17, **caractérisé en ce que** dans une réaction des écoulements de rejet qui contiennent du silane et du dichlorosilane avec le SiCl₄, on utilise des catalyseurs liquides de disproportionation qui ont un point d'ébullition supérieur au point d'ébullition du SiCl₄.

19. Procédé selon au moins l'une des revendications 1 à 18, **caractérisé en ce que** la décomposition thermique du SiH₄ (étape d)) en particules de germes de silicium très pur est réalisée dans un lit fluidisé à une pression de 100 à 900 mbars.

20. Procédé selon au moins l'une des revendications 1 à 19, **caractérisé en ce que** lors de la décomposition thermique du SiH₄, en plus du SiH₄ qui provient de l'étape c), on ajoute jusque 50 % en volume d'un gaz exempt de silicium par rapport à la quantité totale du gaz apporté.

21. Procédé selon la revendication 10, **caractérisé en ce que** comme gaz exempt de silicium, on utilise l'hydrogène.

22. Procédé selon au moins l'une des revendications 1 à 21, **caractérisé en ce que** l'H₂ produit dans l'étape d) est renvoyé dans la réaction du silicium métallurgique avec SiCl₃, H₂ et HCl (étape a)).

23. Procédé selon au moins l'une des revendications 1 à 22, **caractérisé en ce que** lors de la décomposition thermique de SiH₄ purifié (étape d)), on obtient comme sous-produit une poussière de silicium très pur qui est chauffée et agglomérée sous l'action d'un rayonnement de micro-ondes dans la plage de longueurs d'onde de 0,5 kHz à 300 GHz et qui est chauffée à une température d'au moins 300°C.

24. Procédé de fabrication de cellules solaires, qui présente les étapes ci-dessous:
préparation de silicium très pur selon l'une des revendications 1 à 23 et
transformation du silicium très pur ainsi fabriqué en cellules solaires.
